# EUROPÄISCHE PATENTSCHRIFT

(11) **EP 0 462 234 B1**
(45) Veröffentlichungstag und Bekanntmachung des Hinweises auf die Patenterteilung: **31.08.1994**
(21) Anmeldenummer: 90916695.1
(22) Anmeldetag: 20.11.1990
(51) Int. Cl.: H01R 23/68, H01R 13/436, H01R 13/52

(54) **STECKERLEISTE**
PIN CONNECTOR STRIP
CONNECTEUR ELECTRIQUE

(30) Priorität: 10.01.1990 DE 4000548
(43) Veröffentlichungstag der Anmeldung: 27.12.1991
(73) Patentinhaber: ROBERT BOSCH GMBH, 70442 Stuttgart (DE)
(72) Erfinder: MAUE, Hans, D-7120 Bietigheim-Bissingen (DE); SCHAUB, Uwe, D-7143 Vaihingen/Enz 2 (DE); KAHLHAMMER, Hannes, D-7141 Beilstein (DE)
(86) Internationale Anmeldenummer: DE9000895
(87) Internationale Veröffentlichungsnummer: WO9111041

(56) Entgegenhaltungen:
- EP-A- 0 080 813
- DE-A- 3 437 988
- FR-A- 2 538 962
- US-A- 3 993 394

## Beschreibung

Die Erfindung geht aus von einer Steckerleiste, insbesondere für ein elektrisches Schaltgerät, nach dem Oberbegriff des Patentanspruchs 1. Eine solche Steckerleiste ist durch die DE-A-3 437 988 bekannt. Die dort offenbarte Steckerleiste ist geteilt ausgebildet, wobei mehrere Steckverbindungsteile fest in der Steckerleiste angeordnet sind und weitere Steckverbindungsteile sich in einem Einsetzteil befinden. Das Einsetzteil rastet in einer Öffnung des Aufnahmekörpers der Steckerleiste mit Verriegelungshaken hinter Verriegelungskanten des Aufnahmekörpers ein. Diese Verbindung ist schwer lösbar, so daß in einem eingebauten elektrischen Schaltgerät Reparaturen nur mit großem Aufwand vorgenommen werden können.

Des weiteren ist durch die US-A-3 993 394 auf die Befestigung eines Einsatzteils in einem Grundkörper eines elektrischen Verbinders mit Hilfe eines kammartigen Arretierteils verwiesen. Das Arretierteil stützt sich einerseits am Innenmantel des Gehäuses und andererseits an Vorsprüngen am Außenmantel des Gehäuses ab und ist durch diese Befestigungsart und Anordnung nur schwer lösbar.

Aufgabe der Erfindung ist es, die gattungsgemäße Steckerleiste so weiterzubilden, daß eine einfache, sichere Montage möglich ist und eine Demontage mit geringem Aufwand vorgenommen werden kann.

Die Aufgabe wird erfindungsgemäß durch die kennzeichnenden Merkmale des Patentanspruchs 1 gelöst. Insbesondere ist das Arretierteil durch die Durchbrüche des Einsetzteils leicht in die Sacklöcher des Grundkörpers einführbar und demontierbar.

Vorteilhafte Weiterbildungen der Erfindung sind in den Unteransprüchen beschrieben.

### Zeichnung

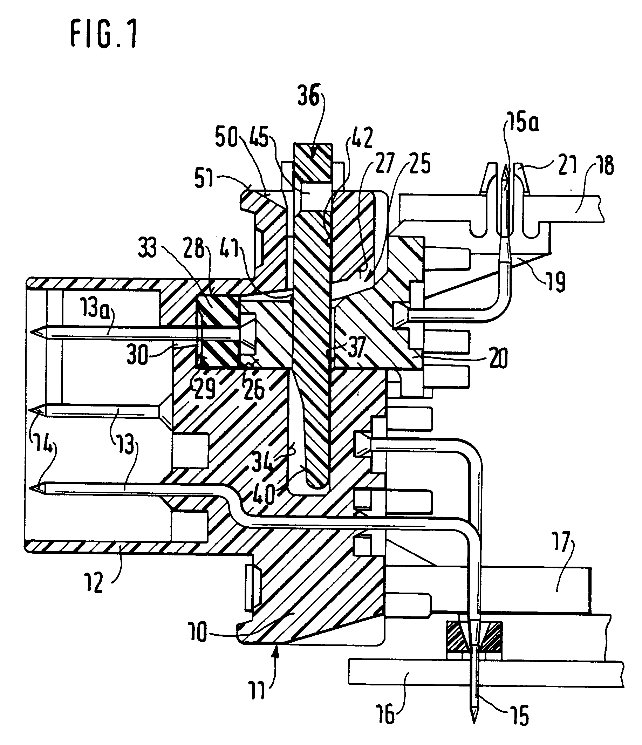

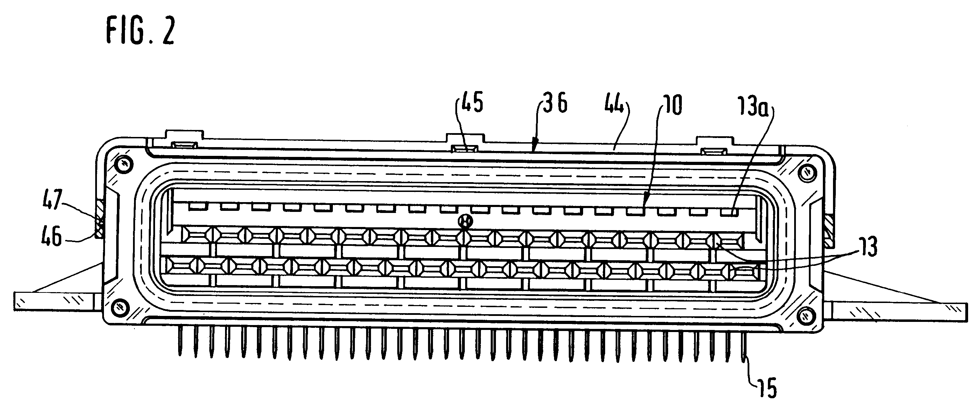

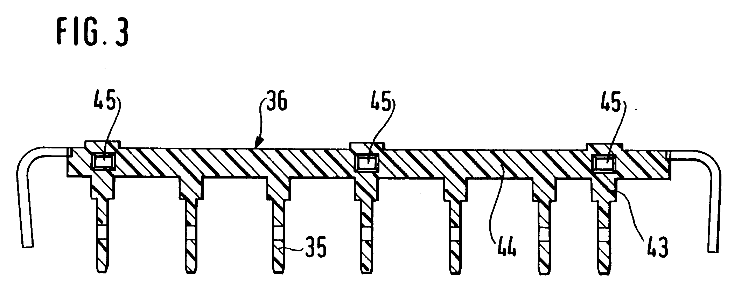

Ein Ausführungsbeispiel der Erfindung ist in der Zeichnung dargestellt und in der nachfolgenden Beschreibung näher erläutert. Es zeigen Figur 1 einen Längsschnitt durch eine Steckerleiste, Figur 2 eine Ansicht in Richtung A nach Figur 1 und Figur 3 eine Einzelheit im Längsschnitt.

### Beschreibung des Ausführungsbeispiels

In Figur 1 ist mit 10 ein aus Kunststoff hergestellter Grundkörper einer Steckerleiste 11 bezeichnet, der an seiner Vorderseite einen Aufnahmekörper 12 zur Aufnahme eines nicht dargestellten Gegensteckers aufweist. In den Grundkörper 10 sind eine Vielzahl von Flachsteckern 13 abgedichtet eingebettet. Dabei ragen die in zwei Reihen angeordneten Flachstecker 13 mit ihren Steckabschnitten 14 in den Aufnahmekörper 12 für den Gegenstecker hinein. Das andere Ende der Flachstecker 13 ist als Anschlußfahne 15 ausgebildet und an einer zugeordneten, nicht näher dargestellten Leiterbahn einer ersten Leiterplatte 16 angelötet. Statt einer Leiterplatte kann auch eine Hybridplatte verwendet werden. Die erste Leiterplatte 16 ist beispielsweise an Schenkeln 17 des Grundkörpers 10 befestigt. Sie kann angeschraubt oder genietet sein.

Nahezu parallel zur ersten Leiterplatte 16 ist eine zweite Leiterplatte 18 an einem Ast 19 eines Einsetzteils 20 mit Hilfe einer Schnappverbindung 21 befestigt. Im Einsetzteil 20 sind weitere Flachstecker 13a abgedichtet eingebettet. Die einen Enden der Flachstecker 13a sind wiederum als Anschlußfahnen 15a ausgebildet, die auf der zweiten Leiterplatte 18 an Leiterbahnen angelötet sind.

Im Grundkörper 10 ist vom Schaltgerät her eine Ausnehmung 25 ausgebildet, deren der ersten Leiterplatte 16 zugewandte Seite 26 senkrecht, vorzugsweise parallel zur ersten Leiterplatte 16 ist. Die gegenüberliegende Seite der Ausnehmung 25 hat eine Einführschräge 27 für das Einsetzteil 20, und einen Endbereich 28, der parallel zur anderen Seite 26 verläuft. Ferner befinden sich im Boden 29 der Ausnehmung 25 eine der Anzahl der Flachstecker 13a entsprechende Anzahl von Fenstern 30. Zwischen dem Einsetzteil 20 und dem Boden 29 der Ausnehmung 25 ist eine Dichtung 33 angeordnet. Der Boden 29 der Ausnehmung 25 und die der Dichtung 33 zugewandte Stirnseite des Einsetzteils 20 sind dichtungsspezifisch ausgeformt. Dadurch wird eine gute Anlage der Dichtung 33, das heißt eine linienhafte Auflage der Dichtung 33 erreicht. Senkrecht zur Ausnehmung 25, das heißt senkrecht zur Seite 26 sind im Grundkörper 10 Sacklöcher 34 ausgebildet, die die Ausnehmung 25 schneiden. In die Sacklöcher 34 eingeführt sind die Zinken 35 eines Kamms 36. Die Anzahl der Zinken 35 und der Sacklöcher 34 soll gleich sein. Der jeweilige Abstand zwischen den einzelnen Zinken 35 muß dem zwischen den jeweiligen Sacklöchern 34 entsprechen. Der Abstand zwischen zwei Zinken 35 weicht von den anderen Abständen ab, so daß eine asymmetrische Form des Kamms 36 erreicht wird. Ferner ist im Einsetzteil 20 eine der Anzahl der Zinken 35 entsprechende Anzahl von Durchbrüchen 37 ausgebildet, die im eingeschobenen Zustand der Zinken 35 achsgleich zu den Sacklöchers 34 sein sollen.

Der Endbereich 40 der Zinken 35 ist auf der dem Boden 29 der Ausnehmung 25 zugewandten Seite keilförmig. In der Figur 1 ist dieser Bereich 40 als zweistufiger Abschnitt dargestellt. Es ist aber auch ein stetiger oder ein anderer, mehrstufiger Verlauf möglich. Im übrigen Bereich 41 verläuft diese Seite der Zinken 35 parallel zur Rückseite 42. Um 90° versetzt zum keilförmigen Bereich 40, das heißt senkrecht zur Zeichenebene der Figur 1 sind an den Zinken 35 Absätze 43 angeordnet, die vorzugsweise rechteckförmigen Querschnitt haben. Die Absätze 43 reichen bis zum Verbindungsbügel 44 des Kamms 36, in dem sich rechteckförmige Demontagelöcher 45 befinden. Am jeweiligen federnden Ende des Verbindungsbügels 44 sind Ausnehmungen 46 vorhanden, in die am Grundkörper 10 angeordnete Nasen 47 einrasten können. Im Bereich der Demontagelöcher 45 sind im Grundkörper 10 der Steckerleiste 11 eine Schräge aufweisende Ausnehmungen 50 angeordnet, so daß eine Schulter 51 entsteht.

Ein lösbarer Flachstecker 13a für die Steckerleiste 11 ist zum Beispiel notwendig, um in einfacher Weise die beiden Leiterplatten 16, 18 auf ihren einander zugewandten Seiten mit elektrischen bzw. elektronischen Bauteilen bestücken zu können. Nach der Bestückung mit den Bauteilen wird mit Hilfe der Schnappverbindung 21 der Ast 19 des Einsetzteils 20 auf der zweiten Leiterplatte 13 befestigt. Anschließend werden die Bauteile und die Anschlußfahnen 15 bzw. 15a auf den Leiterplatten 16, 18 angelötet. Auf die Flachstecker 13a wird die Dichtung 33 aufgeschoben, bis sie am Einsetzteil 20 anliegt. Um einen unverlierbaren Sitz auf den Flachsteckern 13a zu erreichen, sind die Bohrungen der Dichtung 33 geringfügig kleiner ausgebildet als der Querschnitt des Flachsteckers 13a. Ferner reicht die Dichtung 33 über die gesamte Länge des Einsetzteils 20. Nun wird das Einsetzteil 20 in die Ausnehmung 25 eingeführt. Sobald der Flachstecker 13a in das Fenster 30 ragt, gleitet das Einsetzteil 20 entlang der Einführschräge 27 der Ausnehmung 25, bis die Dichtung 33 am Boden 29 der Ausnehmung 25 anliegt. In dieser Position wird das Einsetzteil 20 vorübergehend mit einer zusätzlichen Vorrichtung, bei Handmontage mit der Hand ohne Anpreßdruck gehalten.

Nun wird der Kamm 36 mit seinen Zinken 35 in die Sacklöcher 34 eingeführt. Durch die mehrstufige, keilförmige Form des Bereichs 40 wird erreicht, daß die Zinken 35 durch die Durchbrüche 37 des Einsetzteils 20 ohne jegliche Krafteinwirkung auf das Einsetzteil 20 hindurchgeführt werden können. Erst wenn die Zinken 35 soweit durch die Durchbrüche 37 hindurchgeführt sind, daß die Rückseite 42 der Zinken 35 an der Wand des Sacklochs 34 wieder zum Anliegen kommt, setzt die Keilwirkung des Bereichs 40 ein. Bei weiterem Einführen der Zinken 35 wird durch die Keilform des Bereichs 40 das Einsetzteil 20 zum Boden 29 der Ausnehmung 25 hin bewegt und die Dichtung 33 am Boden 29 angepreßt. Sobald der parallele Bereich 41 in die Durchbrüche 37 eingeführt wird, ist die gewünschte Endlage des Einsetzteils 20 erreicht. Für eine sichere Endlage werden die Zinken 35 so weit eingeführt, bis die Anschläge 43 der Zinken 35 am Einsetzteil 20 anliegen. Gleichzeitig rasten in dieser Position auch die Nasen 47 des Grundkörpers 10 in die Ausnehmungen 46 des Verbindungsbügels 44 ein. Dadurch ist der Kamm 36 unverlierbar mit dem Grundkörper 10 verbunden.

Um einen Zugriff zu den Bestückungsseiten der beiden Leiterplatten 16, 18 zu haben, muß der Kamm 36 und somit das Einsetzteil 20 demontierbar sein. Hierzu wird der Bügel 44 im Bereich der Nasen 47 aufgespreizt. Anschließend wird mit einem Werkzeug in alle drei Demontagelöcher 45 des Kamms 36 eingegriffen. Das Werkzeug wird dabei an der Schulter 51 angelegt, so daß bei einer Schwenkbewegung des Werkzeugs ein Gegenlager und eine Hebelwirkung entsteht. Dadurch können in der Anfangsphase des Herausziehens der Kamm 36 und somit die Zinken 35 mit geringem Kraftaufwand in den Sacklöchern 34 angehoben werden. Sobald die Hebelwirkung über die Schulter 51 vorüber ist, wird das Werkzeug als Ausziehwerkzeug verwendet. Dies ist möglich, da aufgrund des keilförmigen Bereichs der Zinken 35 die Klemmkraft zwischen den Zinken 35 und dem Einsetzteil 20 nachläßt. Das Einsetzteil 20 kann nun aus der Ausnehmung 25 herausgenommen werden. Eine Montage und eine Demontage ist beliebig oft wiederholbar.

## Patentansprüche

1. Steckerleiste (11), insbesondere für ein elektrisches Schaltgerät, mit einem Grundkörper (10), mit mehreren ersten Steckverbindungsteilen (13), die abgedichtet aus dem Grundkörper (10) geführt und mit elektrischen Bauteilen verbunden sind, mit mehreren zweiten Steckverbindungsteilen (13a), die in einem in den Grundkörper (10) einfügbaren Einsetzteil (20) angeordnet sind, wobei der Grundkörper (10) zum Einsetzteil (20) hin mit Hilfe eines Dichtmittels (33) abgedichtet ist, dadurch gekennzeichnet, daß das Einsetzteil (20) mit Hilfe eines kammartigen Arretierteils (36) im Grundkörper (10) befestigt und das Arretierteil (36) in Durchbrüche (37) des Einsetzteils und Sacklöcher (34) des Grundkörpers (10) einsetzbar ist.

2. Steckerleiste nach Anspruch 1, dadurch gekennzeichnet, daß das Arretierteil (36) Zinken (35) mit einem dem Dichtmittel (33) zugewandten, keilförmigen Bereich (40) und einen Bereich (41) mit zur Rückseite parallelen Flächen aufweist.

3. Steckerleiste nach Anspruch 2, dadurch gekennzeichnet, daß der keilförmige Bereich (40) der Zinken (35) aus mehreren Abschnitten mit unterschiedlichen Keilwinkeln besteht.

4. Steckerleiste nach einem der Ansprüche 1 bis 3, dadurch gekennzeichnet, daß der parallele Bereich (41) der Zinken (35) mindestens einen Absatz (43) aufweist, der um 90° zum keilförmigen Bereich (40) versetzt ist und einen größeren Querschnitt aufweist als der im Einsetzteil (20) ausgebildeten Durchbrüche (37), in die die Zinken (35) einsetzbar sind.

5. Steckerleiste nach einem der Ansprüche 1 bis 4, dadurch gekennzeichnet, daß der Abstand zwischen den Zinken (35) des Arretierteils (36) unterschiedlich ist.

6. Steckerleiste nach einem der Ansprüche 1 bis 5, dadurch gekennzeichnet, daß die Anordnung der Zinken (35) des Arretierteils (36) asymmetrisch ist.

7. Steckerleiste nach einem der Ansprüche 1 bis 6, dadurch gekennzeichnet, daß das Arretierteil im die Zinken (35) verbindenden Bügel (44) mehrere Ausnehmungen (45) aufweist.

8. Steckerleiste nach einem der Ansprüche 1 bis 7, dadurch gekennzeichnet, daß das Arretierteil (36) am Grundkörper (10) mit Hilfe einer formschlüssigen Verbindung befestigt ist.

9. Steckerleiste nach Anspruch 8, dadurch gekennzeichnet, daß die Verbindung aus einer am Grundkörper (10) angeordneten Nase (47) und einer Ausnehmung (46) im Bügel (44) besteht.

10. Steckerleiste nach einem der Ansprüche 1 bis 9, dadurch gekennzeichnet, daß im Grundkörper (10) Schultern (51) angeordnet sind, die sich im Rastzustand des Arretierteils (36) im Bereich der Ausnehmungen (45) des Arretierteils (36) befinden, so daß ein in die Ausnehmungen (45) angesetztes Demontagegerät abgestützt werden kann.

## Claims

1. Push-on terminal strip (11), in particular for an electrical switching device, having a basic body (10), having a plurality of first plug-in connecting parts (13) which are guided out of the basic body (10) in a sealed fashion and connected to electrical components, and having a plurality of second plug-in connecting parts (13a) which are arranged in an insert part (20) which can be inserted into the basic body (10), the basic body (10) being sealed with the aid of sealing means (33) with respect to the insert part (20), characterized in that the insert part (20) is mounted in the basic body (10) with the aid of a comb-like locking part (36) and the locking part (36) can be inserted into cutouts (37) in the insert part and into blind holes (34) in the basic body (10).

2. Push-on terminal strip according to Claim 1, characterized in that the locking part (36) exhibits teeth (35) having a wedge-shaped region (40) facing the sealing means (33), and a region (41) having surfaces parallel to the rear.

3. Push-on terminal strip according to Claim 2, characterized in that the wedge-shaped region (40) of the teeth (35) consists of a plurality of sections having different wedge angles.

4. Push-on terminal strip according to one of Claims 1 to 3, characterized in that the parallel region (41) of the teeth (35) exhibits at least one shoulder (43) which is offset by 90° relative to the wedge-shaped region (40) and exhibits a larger cross-section than the cutouts (37), which are constructed in the insert part (20) and into which the teeth (35) can be inserted.

5. Push-on terminal strip according to one of Claims 1 to 4, characterized in that the distance between the teeth (35) of the locking part (36) is variable.

6. Push-on terminal strip according to one of Claims 1 to 5, characterized in that the arrangement of the teeth (35) of the locking part (36) is asymmetric.

7. Push-on terminal strip according to one of Claims 1 to 6, characterized in that the locking part exhibits a plurality of recesses (45) in the bow (44) connecting the teeth (35).

8. Push-on terminal strip according to one of Claims 1 to 7, characterized in that the locking part (36) is mounted on the basic body (10) with the aid of a positive connection.

9. Push-on terminal strip according to Claim 8, characterized in that the connection consists of a nose (47) arranged on the basic body (10) and a recess (46) in the bow (44).

10. Push-on terminal strip according to one of Claims 1 to 9, characterized in that there are arranged in the basic body (10) shoulders (51) which are located in the state of rest of the locking part (36) in the region of the recesses (45) in the locking part (36), so that it is possible to support a dismantling device which is applied in the recesses (45).

## Revendications

1. Connecteur électrique multibroche, destiné notamment à un appareil de commutation, comprenant un corps principal (10) d'où dépasse une première série de broches de liaison (13) montées de manière étanche dans le corps principal et reliées à des composants électriques, une deuxième série de broches de liaison (13a) montées dans une partie (20) emmanchable dans le corps principal (10), la liaison entre le corps principal (10) et la partie emmanchable étant réalisée de manière étanche par un joint d'étanchéité (33), caractérisé en ce que la partie emmanchable (20) est fixée dans le corps principal (10) par l'intermédiaire d'un organe d'arrêt (36) en forme de peigne gui peut être enfoncé dans des ouvertures (37) du corps emmanchable et les trous borgnes (34) du corps principal (10).

2. Connecteur électrique selon la revendication 1, caractérisé en ce que l'organe d'arrêt (36) est équipé de dents (35) comprenant une partie (40) en forme de coin, tournée vers l'étanchéité (33) et une partie (41) comprenant des surfaces parallèles à la face arrière.

3. Connecteur électrique selon la revendication 2, caractérisé en ce que la partie en coin (40) des dents (35) comporte plusieurs sections présentant des angles de coin différents.

4. Connecteur électrique selon une des revendications 1 à 3, caractérisé en ce que la partie (41) à faces parallèles des dents (35) présente un élargissement (43) décalé à 90° de la partie en coin (40) et de section supérieure aux ouvertures (37) de la partie emmanchable (20) dans lesquelles sont enfoncées des dents (35).

5. Connecteur selon une des revendications 1 à 4, caractérisé en ce que la distance entre les dents (35) de l'organe d'arrêt (36) sont différentes.

6. Connecteur selon une des revendications 1 à 5, caractérisé en ce que la distance entre les dents (35) de l'organe d'arrêt (36) est asymétrique.

7. Connecteur électrique selon une des revendications 1 à 6, caractérisé en ce que l'organe d'arrêt présente plusieurs évidements (45) pratiqués dans l'étrier (44) reliant les dents (35).

8. Connecteur électrique selon une des revendication 1 à 7, caractérisé en ce que l'organe d'arrêt (36) est fixé sur le corps principal (10) par une liaison par la forme.

9. Connecteur électrique selon la revendication 8, caractérisé en ce que la liaison est constituée par un talon (47) disposé sur le corps principal (10) et un évidement (46) de l'étrier (44).

10. Connecteur électrique selon une des revendications 1 à 9, caractérisé en ce que le corps principal (10) présente des épaulements (51) qui, dans la position active de l'organe d'arrêt (36) se trouvent en regard des évidements (45) de l'organe d'arrêt (36) et peuvent ainsi servir d'appui à un outil de démontage engagé dans ces évidements (45).
